# EUROPEAN PATENT APPLICATION

(11) **EP 4 130 356 A1**
(43) Date of publication of application: **08.02.2023**
(21) Application number: 21776987.6
(22) Date of filing: 26.03.2021
(51) Int. Cl.: D01F 9/08, B22F 7/06, C01G 53/00, C04B 35/468, D01F 8/18, H01L 41/09, H01L 41/113, H01L 41/187

(54) **COMPOSITE FIBER**

(30) Priority: 26.03.2020 JP 2020056310
(71) Applicant: Murata Manufacturing Co., Ltd., Nagaokakyo-shi, Kyoto 617-8555 (JP)
(72) Inventor: TANAKA, Kou, Nagaokakyo-shi, Kyoto 617-8555 (JP); TATEISHI, Takashi, Nagaokakyo-shi, Kyoto 617-8555 (JP); YAMADA, Takaaki, Nagaokakyo-shi, Kyoto 617-8555 (JP)
(74) Representative: Reeve, Nicholas Edward
(86) International application number: PCT/JP2021/013029
(87) International publication number: WO 2021/193956

(57) **Abstract**

Provided is a composite fiber composed of at least a metal sintered body and a ceramic sintered body. In the composite fiber, the metal sintered body and the ceramic sintered body are adjacent to each other to form a fiber body.

## Description

### TECHNICAL FIELD

The present invention relates to a composite fiber, and more specifically to a composite fiber that may be composed of at least a metal sintered body and a ceramic sintered body.

### BACKGROUND ART

There are known piezoelectric fibers using lead zirconate titanate fibers (PZT fibers) as vibration sensors and actuators usable for structures such as buildings, automobiles, ships, and aircraft (for example, Patent Documents 1 to 6). There are also known smart boards in which such a PZT fiber is embedded in a structure to cause the PZT fiber to function as a stress sensor, a vibration sensor, or an actuator (for example, Patent Document 1).

### PRIOR ART DOCUMENTS

### PATENT DOCUMENTS

Patent Document 1: Japanese Patent Application No. 2003-12829
Patent Document 2: Japanese Patent Application No. 2005-171752
Patent Document 3: Japanese Patent Application No. 2004-15489
Patent Document 4: Japanese Patent Application No. 2005-59552
Patent Document 5: Japanese Patent Application No. 2005-313715
Patent Document 6: Japanese Patent Application No. 2010-198092

### SUMMARY OF THE INVENTION

### Problem to be solved by the invention

The inventors of the present application have noticed that conventional lead zirconate titanate fibers (PZT fibers) have problems to be overcome and have found a need to take measures for the problems. Specifically, the inventors of the present application have found that there are the following problems.

For example, as illustrated in FIG. 11(A), a lead zirconate titanate fiber (PZT fiber) 100 described for example in Patent Document 1 includes a PZT thin layer 102 that may be formed by coating a metal wire 101 (a metal thin wire such as a titanium wire or a platinum wire) with a lead zirconate titanate crystal (PZT crystal).

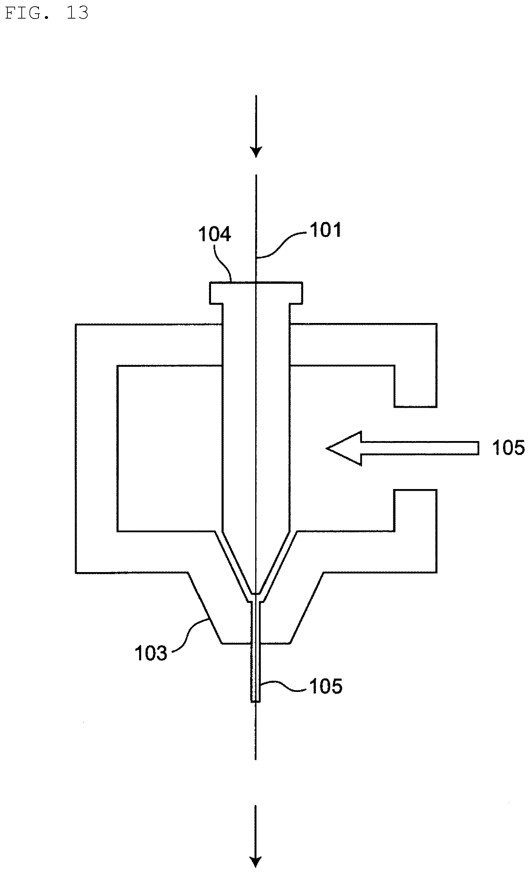

The PZT fiber may be produced by growing a PZT crystal on the surface of the metal wire for example by a hydrothermal synthesis method. The PZT fiber may also be produced by an extrusion molding method. In the extrusion molding method as illustrated for example in FIG. 13, a PZT paste 105 (in which PZT powder, a binder, water, and as necessary, an organic solvent, various molding additives, and the like are added and kneaded) is co-extruded with the metal wire 101 to produce a PZT fiber molded body including a metal core, then the PZT fiber molded body is heated to undergo a process of debinding, and thereafter sintered at a higher temperature to produce a PZT fiber in which a PZT thin layer is formed on the surface of the metal wire.

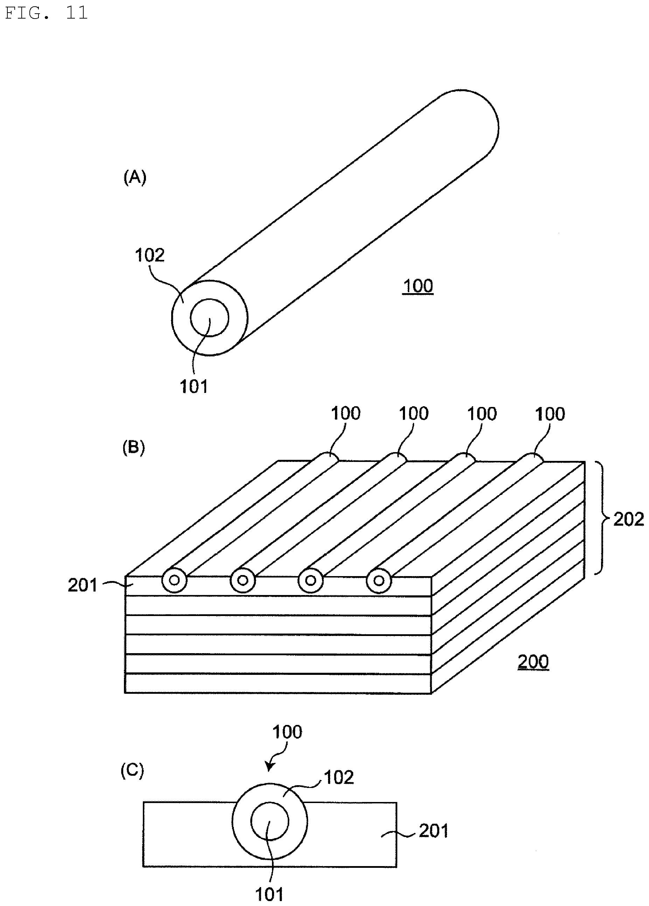

The PZT fiber that may be produced by a hydrothermal synthesis method, an extrusion molding method, or the like as described above has a structure in which the surface of the metal wire is simply coated with the PZT crystal, and therefore the PZT thin layer 102 cracks easily. For example, when the PZT fiber is used for a vibration sensor, an actuator, or the like (particularly when the PZT fiber is used in the field of aircraft), as illustrated for example in FIGS. 11(B) and (C), a part of the PZT fiber 100 is embedded in a structure 202 formed by stacking a prepreg 201 of carbon fiber reinforced plastic (CFRP) to reinforce the structure, and the structure is used as a smart board 200 (see FIGS. 11(B) and (C)).

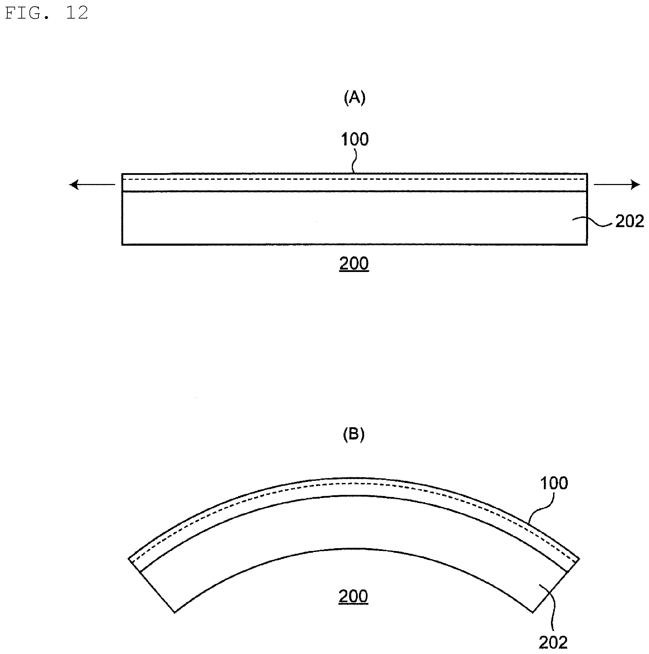

For example, when the smart board 200 is used as a vibration sensor or an actuator, the PZT fiber 100, which is a piezoelectric material, detects vibration and generates a potential to function as a sensor, and conversely, when a potential is applied to the PZT fiber 100, the PZT fiber extends or vibrates according to the potential to function as an actuator. For example, when the PZT fiber 100 extends along an axial direction indicated by an arrow because of the application of a potential as illustrated in FIG. 12(A), the PZT fiber can curve together with the structure 202 as illustrated in FIG. 12 (B). In this manner, in the smart board 200, a predetermined PZT fiber among the plurality of PZT fibers 100 functions as a sensor to detect vibration, and another predetermined PZT fiber can operate as an actuator to inhibit (dampen) the vibration. Note that the part of the PZT fiber 100 below the broken line in FIG. 12 indicates that the PZT fiber 100 is embedded in the structure 202 (specifically, the prepreg 201 of CFRP) (see FIG. 11(C)).

When a PZT fiber is used in a vibration sensor or an actuator as described above, the PZT fiber needs to have a certain degree of strength and flexibility. However, the inventors of the present application have found, from the contents described in the July issue of Polymers of The Society of Polymer Science (Vol. 57 No. 7, 2008), that the strength (tensile strength or breaking elongation load) of a conventional PZT fiber is about 4 kgf/mm², and the PZT fiber breaks, cuts, or cracks easily as a fiber and needs to have further improved strength.

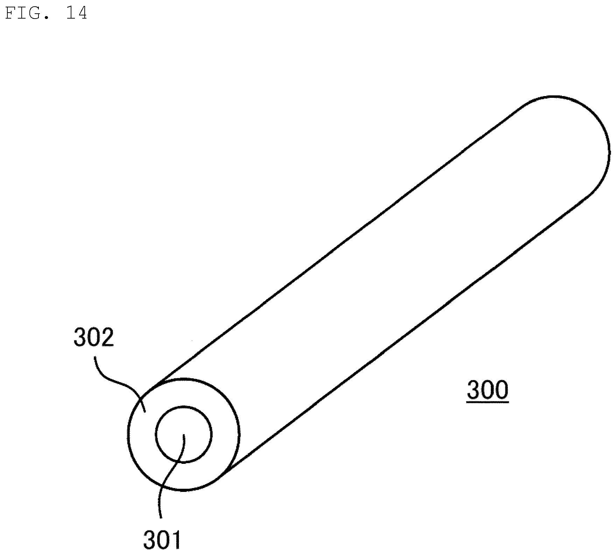

It was also found that in a PZT fiber 300 as illustrated in FIG. 14 in which a PZT film 302 is formed on a metal thin wire 301 made of platinum (Pt) or the like, interlayer peeling occurs between the PZT and the metal thin wire (Pt) due to a difference in thermal expansion coefficient, and the PZT fiber cracks easily from the interface. This causes the fiber to have low physical strength.

The present invention has been made in view of such problems. That is, a main object of the present invention is to provide a composite fiber having higher strength than a conventional PZT fiber that may function as a piezoelectric material.

### Means for solving the problem

The inventors of the present application have attempted to solve the above problems by addressing the problems in a new direction instead of addressing the problems in an extension of the conventional technique. As a result, the inventors have reached the invention of a composite fiber in which the above main object is achieved.

The present invention provides a composite fiber that may be composed of at least a metal sintered body and a ceramic sintered body, in which the metal sintered body and the ceramic sintered body are adjacent to each other to form a fiber body.

### Advantageous effect of the invention

In the present invention, obtained is a composite fiber having higher strength than a conventional PZT fiber that may function as a piezoelectric material. More specifically, obtained is a composite fiber in which interlayer peeling is remarkably inhibited, having a tensile strength of 5 kgf/mm² or more, preferably 6 kgf/mm² or more. In addition, obtained is a composite fiber having flexibility with which the composite fiber has a radius of curvature of 200 mm or less, preferably 10 mm or less when bent. Note that the effects described in the present specification are merely examples and are not limited, and additional effects may be provided.

### BRIEF EXPLANATION OF DRAWINGS

FIG. 1 includes a schematic view of a composite fiber according to an embodiment of the present invention.
FIG. 2 is a schematic sectional view of a section of a metal sintered body and a ceramic sintered body adjacent to each other and contained in the composite fiber according to an embodiment of the present invention, particularly an interface between the metal sintered body and the ceramic sintered body.
FIG. 3 is an electron micrograph of an interface between a metal sintered body (Ni) composed of a crystal grain and a ceramic sintered body (BT) also composed of a crystal grain.
FIG. 4 includes a schematic view of a composite fiber according to another embodiment of the present invention.
FIG. 5 includes a schematic view of a composite fiber according to another embodiment of the present invention.
FIG. 6(A) is a schematic perspective view of a composite fiber according to another embodiment of the present invention, and FIG. 6(B) is a section taken along the line Y-Y' of the composite fiber of FIG. 6(A).
FIG. 7 is an electron micrograph of a section of a composite fiber composed of a metal core (Ni), a first layer (Ni crystal grain layer), and a second layer (BaTiO₃ crystal grain layer) .
FIG. 8 includes a schematic view illustrating an example of a method for producing a composite fiber.
FIG. 9 is an electron micrograph (5.0 kV, 2500 magnifications) of a section of a metal sintered body (Ni) and a ceramic sintered body (BT) adjacent to each other and contained in a composite fiber produced in Example 1 of the present invention.
FIG. 10 is an electron micrograph (5.0 kV, 2500 magnifications) of a section of a metal sintered body and a ceramic sintered body adjacent to each other and contained in a composite fiber produced in Comparative Example 1.
FIG. 11 includes a schematic view of a conventional PZT fiber and a schematic view of a smart board in which the PZT fiber is embedded in a structure.
FIG. 12 includes a schematic view illustrating a case where a conventional smart board is used as a vibration sensor and an actuator.
FIG. 13 is a schematic view illustrating an example of a method for producing a conventional PZT fiber.
FIG. 14 is a schematic view of a conventional PZT fiber.

### MODE FOR CARRYING OUT THE INVENTION

The present invention relates to a composite fiber, and more specifically to a composite fiber that may be composed of or formed of at least a "metal sintered body" and a "ceramic sintered body", wherein the metal sintered body and the ceramic sintered body are adjacent to each other to form a fiber body (hereinafter, the composite fiber is also referred to as "composite fiber of the present disclosure" or simply "composite fiber" or "fiber").

The composite fiber of the present disclosure has a higher strength than conventional piezoelectric fibers, such as PZT fibers. A conventional PZT fiber has a structure in which a "metal wire" is simply covered with a "PZT crystal", and thus has a strength (tensile strength, elongation at break load) of only about 4 kgf/mm² and interlayer peeling occurs as described above, which causes the fiber alone to break easily. When such a PZT fiber is used in a vibration sensor or an actuator, the PZT fiber needs to be reinforced by a structure such as a carbon fiber reinforced plastic (CFRP) prepreg as illustrated for example in FIG. 11(B).

However, as described in detail below, the composite fiber of the present disclosure has a structure in which a "metal sintered body" and a "ceramic sintered body" are adjacent to each other to form a fiber body, and therefore can achieve a strength (tensile strength, breaking elongation load, and the like) of, for example, 5 kgf/mm² or more, preferably 6 kgf/mm² or more.

In addition, since such an increase in strength enables the composite fiber to be downsized, the composite fiber of the present disclosure can exhibit flexibility with which the composite fiber has a radius of curvature when bent of, for example, 200 mm or less, or preferably 10 mm or less, which is smaller than the radius of curvature of a conventional PZT fiber.

In this manner, the composite fiber of the present disclosure has performance such as excellent strength and flexibility as compared with the conventional PZT fiber. Such performance is caused by a structure in which a "metal sintered body" and a "ceramic sintered body" are adjacent to each other to form a "fiber body", particularly a structure in which the "metal sintered body" and the "ceramic sintered body" are bonded to each other by co-sintering. Note that the invention of the present application and the effects thereof are not limited to a specific theory or the like.

### (Composite fiber)

The term "composite fiber" usually means a fiber that may be composed of two or more different materials, and in the composite fiber of the present disclosure, it means a fiber that includes at least a "metal sintered body" and a "ceramic sintered body".

In the present disclosure, the term "fiber body" (or "composite fiber" or "fiber") means an elongated object or article, and the length thereof is not particularly limited. In the present disclosure, the shape of the "fiber body", particularly the shape of a section is not particularly limited, and the "fiber body" may have, for example, a circular, elliptical, rectangular, or irregular section.

In the present disclosure, the term "metal sintered body" means a metal or alloy formed by firing at least the "metal component" described below, preferably a metal simple substance. In other words, the "metal component" may be a component that may constitute the "metal sintered body". The "metal component" may also be a component that may be contained in the "metal sintered body".

In the present disclosure, the "metal component" is not particularly limited as long as it is a component (element) that may constitute a metal (preferably a metal simple substance), and is composed of, for example, at least one selected from the group consisting of silver (Ag), palladium (Pd), copper (Cu), aluminum (Al), chromium (Cr), titanium (Ti), platinum (Pt), iron (Fe), and nickel (Ni) (hereinafter, the metal component may be referred to as a "metal element"). In the composite fiber of the present disclosure, the metal component is preferably nickel or copper.

In the composite fiber of the present disclosure, the metal sintered body is preferably nickel (metal simple substance) or copper (metal simple substance), and more preferably has a structure in which particles or crystal grains of nickel metal (element) or copper metal (element) are bonded to each other.

In the present disclosure, the term "ceramic sintered body" means a ceramic, preferably a ceramic crystal, formed by firing at least the "ceramic component" described below. In other words, the "ceramic component" may be a component that may constitute the "ceramic sintered body". The "ceramic component" may also be a component that may be contained in the "ceramic sintered body".

In the present disclosure, the "ceramic component" is not particularly limited as long as it is a component (element) that may constitute a ceramic (ceramic crystal, in particular metal oxide), and is composed of, for example, at least one selected from the group consisting of lithium (Li), sodium (Na), potassium (K), magnesium (Mg), calcium (Ca), strontium (Sr), barium (Ba), yttrium (Y), zirconium (Zr), titanium (Ti), vanadium (V), chromium (Cr), manganese (Mn), iron (Fe), cobalt (Co), nickel (Ni), copper (Cu), zinc (Zn), boron (B), aluminum (Al), silicon (Si), indium (In), tin (Sn), antimony (Sb), barium (Ba), tantalum (Ta), tungsten (W), lead (Pb), bismuth (Bi), lanthanum (La), cesium (Ce (Ce (Ce), neodymium (Ce (Ce), neodymium (Nd), samarium (Sm), gadolinium (Gd), dysprosium (Dy), holmium (Ho), erbium (Er), oxygen (O), carbon (C), nitrogen (N), sulfur (S), phosphorus (P), fluorine (F), and chlorine (Cl) (hereinafter, the ceramic component may be referred to as a "ceramic element"). In the composite fiber of the present disclosure, the ceramic component is preferably titanium, barium, and oxygen, or bismuth, sodium, titanium, and oxygen.

The ceramic component may contain a glass component. Examples of the glass component include at least one selected from the group consisting of soda lime glass, potassium glass, borate glass, borosilicate glass, barium borosilicate glass, zinc borate glass, barium borate glass, bismuth borosilicate glass, bismuth zinc borate glass, bismuth silicate glass, phosphate glass, aluminophosphate glass, and zinc phosphate glass.

In the composite fiber of the present disclosure, the ceramic sintered body preferably contains a crystal grain or a microcrystal, and in particular, the composite fiber is more preferably barium titanate (BaTiO₃) (BT), bismuth sodium titanate ((Bi_{1/2}Na_{1/2})TiO₃) (BNT), or glass.

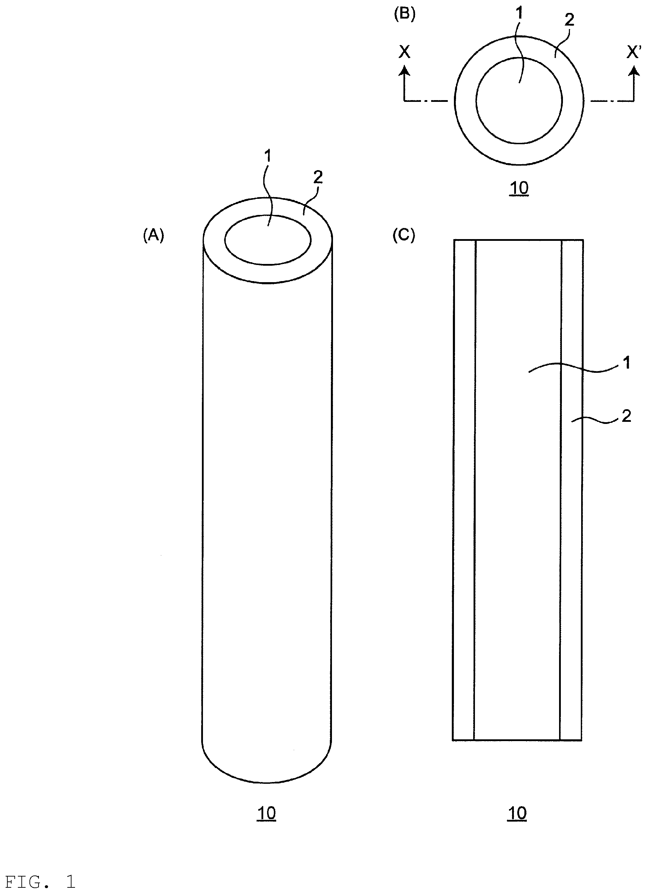

The composite fiber according to an embodiment of the present invention is, as illustrated for example in FIG. 1(A), a composite fiber 10 that may be composed of at least a metal sintered body 1 and a ceramic sintered body 2. FIG. 1(B) schematically illustrates a section of the composite fiber 10 (a section in a direction perpendicular to an axial direction of the fiber), and FIG. 1(C) schematically illustrates a section taken along the line X-X' in FIG. 1(B) (a section in the axial direction of the fiber).

For example, FIG. 1 illustrates the composite fiber 10 in which the metal sintered body 1 having a substantially circular cross section and the ceramic sintered body 2 are disposed in a substantially concentric fashion. The section of the composite fiber of the present disclosure is not limited to a circular shape or a concentric shape.

The metal sintered body 1 and the ceramic sintered body 2 may be integrally formed or produced as described in detail below. For example, it is preferable to integrally form or produce the metal sintered body 1 and the ceramic sintered body 2 by co-sintering the metal component and the ceramic component described above. More specifically, the metal sintered body 1 and the ceramic sintered body 2 can be integrally formed or produced by forming a paste containing the metal component (metal element) and a paste containing the ceramic component (ceramic element) into desired shapes and then firing them by co-sintering.

The forming method into the desired shape is not limited to the method using a paste, and the metal sintered body and the ceramic sintered body can also be formed and produced by a chemical vapor deposition method such as thermal CVD of the metal component (metal element) and the ceramic component (ceramic element) or a physical vapor deposition method such as sputtering.

For example, as illustrated in FIG. 1, in the composite fiber of the present disclosure, the metal sintered body and the ceramic sintered body are adjacent to (in contact with or facing or bonded to) each other to constitute a fiber body. With such a configuration, the composite fiber of the present disclosure can achieve improved strength, flexibility, effect of inhibiting interlayer peeling, and the like as compared with the conventional PZT fiber.

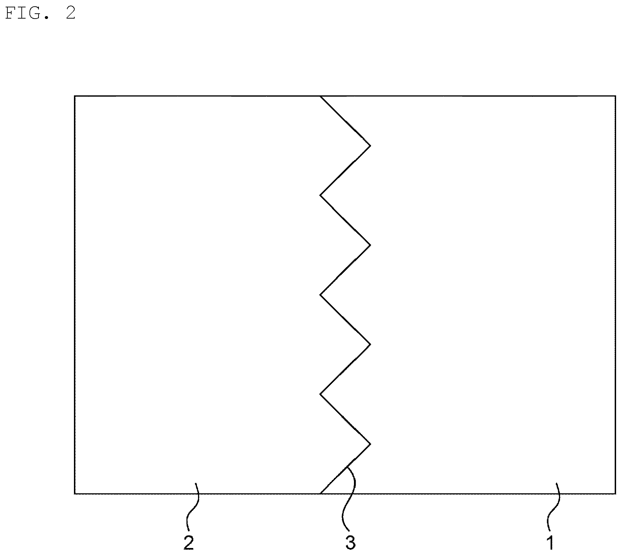

More specifically, as illustrated for example in FIG. 2, in the composite fiber of the present disclosure, the metal sintered body 1 and the ceramic sintered body 2 are disposed adjacent to each other. The metal sintered body 1 and the ceramic sintered body 2 may be configured to form an interface 3.

In the present disclosure, the term "interface" means a boundary between adjacent "metal sintered body" and "ceramic sintered body".

The interface that may be formed by the metal sintered body and the ceramic sintered body may be composed of crystal grains. In the present disclosure, the term "crystal grain" means a microcrystal of about 1/20000 mm to 1/10 mm having an irregular shape.

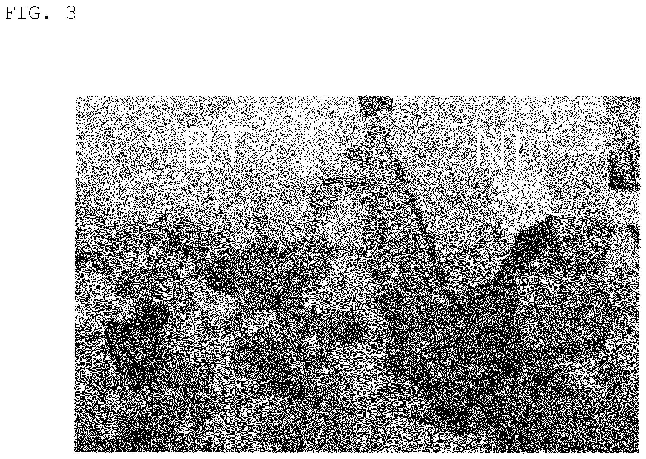

The metal sintered body may be composed of a crystal grain of metal (or metal component) (see FIG. 3). In other words, the metal sintered body may be a polycrystalline body of metal (or metal component). The size of the crystal grain in the metal sintered body (hereinafter, it may be referred to as "crystal grain size" of metal crystal grain) is not particularly limited. The size of the crystal grain in the metal sintered body is, for example, 0.1 um to 10 um. Here, the size of the crystal grain in the metal sintered body means the maximum dimension of a crystal grain or a microcrystal in a sectional view.

The size of the crystal grain that may be contained in the metal sintered body may depend on the metal component, and for example, the particle size of the powder of the metal component before firing is preferably 0.05 um to 5 µm.

The ceramic sintered body may be composed of a crystal grain of ceramic (or ceramic component) (see FIG. 3). In other words, the ceramic sintered body may be a polycrystalline body of ceramic (or ceramic component). The size of the crystal grain in the ceramic sintered body (hereinafter, it may be referred to as "crystal grain size" of ceramic crystal grain) is not particularly limited. The size of the crystal grain in the ceramic sintered body is, for example, 0.1 um to 10 um. Here, the size of the crystal grain in the ceramic sintered body means the maximum dimension of a crystal grain or a microcrystal in a sectional view.

The size of the crystal grain that may be contained in the ceramic sintered body may depend on the ceramic component, and for example, the particle size of the powder of the ceramic component before firing is preferably 0.05 um to 5 µm.

Referring now to FIG. 2, the metal sintered body 1 is preferably composed of a crystal grain of metal (or metal component), and the ceramic sintered body 2 is preferably composed of a crystal grain of ceramic (or ceramic component). It is more preferable that both the metal sintered body 1 and the ceramic sintered body 2 be formed by co-sintering (see FIG. 3). This is because the crystal grain or microcrystal can be formed through crystal growth in both the metal sintered body and the ceramic sintered body by co-sintering.

In the composite fiber of the present disclosure, an interface may be formed between a crystal grain that may constitute the metal sintered body and a crystal grain that may constitute the ceramic sintered body (see FIG. 3). The boundary of the crystal grain is also called a grain boundary, and such a grain boundary may form an interface between the metal sintered body and the ceramic sintered body. Alternatively, the interface may be formed between the metal sintered body and the ceramic sintered body to share a part of the grain boundary or a part of the outline of the crystal grain.

At this time, the crystal grain that may constitute the metal sintered body are preferably crystal grain that may be formed through crystal growth of metal (or a metal component) (see FIG. 3).

The crystal grain that may constitute the ceramic sintered body are preferably crystal grain that may be formed through crystal growth of ceramic (or ceramic component) (see FIG. 3).

It is more preferable that the crystal growth proceed in the step of firing or co-sintering the metal and/or ceramic.

The crystal growth of metal and ceramic can be more appropriately controlled by the firing temperature, the temperature increase rate, the holding time, the temperature decrease rate, the atmosphere, the pressure, the sintering aid, the additive element, and the like.

In the composite fiber of the present disclosure, an interface may have a "face roughness". In particular, when the interface may be formed of a crystal grain in the composite fiber of the present disclosure, the interface preferably has a "face roughness" (see FIGS. 2 and 3). In other words, the interface may have irregularities, particularly fine irregularities based on the crystal grain, and such an interface may be non-linear in a sectional view (see FIGS. 2 and 3) and does not have to be linear. In other words, the interface may have a shape like a polygonal line in a sectional view (see FIGS. 2 and 3).

In addition, such an interface does not have a clearance, a gap, or a void in a sectional view. Conventionally, there has been a problem of causing interlayer peeling and insufficient strength since the boundary between the metal and the ceramic is linear and has a clearance or the like in a sectional view. In the composite fiber of the present disclosure, the face roughness or fine irregularities of the interface can solve the problem of interlayer peeling and insufficient strength.

In the present disclosure, the "face roughness" is referred to as "surface roughness" or "roughness on surface" because it indicates the degree of unevenness of the interface and may be simply referred to as "roughness". The "face roughness" may be defined, for example, by measuring "line roughness" in a sectional view of the interface from an electron micrograph or the like. In the present disclosure, "face roughness" is a term that can be used interchangeably with "line roughness".

Specifically, the difference in the interface structure can be determined by calculating the line roughness of the interface formed of the metal sintered body and the ceramic sintered body and the line roughness of the interface formed of the metal body and the ceramic sintered body.

For example, SEM observation is performed after polishing a sample section of the composite fiber of the present disclosure. Three visual fields in which the line roughness of the interface can be determined are randomly extracted from the SEM image. A straight line connecting two intersections of an end surface of the visual field image extracted using image analysis software and the interface between the metal sintered body and the ceramic sintered body is defined as a center line, and the distance between the actual boundary and the center line is measured at 30 points at equal intervals along the center line. The line roughness can be evaluated by the average value and standard deviation of these distances.

A specific line roughness value (measured value) is, for example, 15 nm or more and 1000 nm or less, preferably 75 nm or more and 300 nm or less, and more preferably 100 nm or more and 300 nm or less.

The standard deviation (SD) of the distance between the boundary and the center line is, for example, 12 nm or more and 500 nm or less, preferably 50 nm or more and 150 nm or less.

When the crystal grain of the metal sintered body and the crystal grain of the ceramic sintered body may form an interface as illustrated for example in FIGS. 2 and 3, the interface can have surface roughness or irregularities spreading two-dimensionally or three-dimensionally because similar line roughness can be confirmed also in the depth direction in a sectional view.

The interface having such face roughness can improve the degree of close contact between the metal sintered body and the ceramic sintered body, inhibits interlayer peeling, and can achieve a composite fiber having more improved fracture strength. Further, the presence of such a crystal grain enables a structure to be obtained in which the residual stress caused by the thermal history during the process is uniformly relaxed.

Such a crystal grain may be composed of a plurality of or a large number of crystallites or may be composed of a single crystallite.

The metal component and the ceramic component may be clearly separated, or at least a part thereof may be mixed with each other.

In addition, the region near the interface may contain a non-crystalline part. The region near the interface may be therefore non-crystalline or crystalline, or both a noncrystalline part and a crystalline part may be present there.

In the present disclosure, "non-crystalline" (sometimes referred to as amorphous) means a noncrystalline state.

In the present disclosure, the "region near the interface" specifically means a region adjacent to the interface, and is, for example, a region within a range of 1500 nm, preferably 500 nm from the interface.

The metal sintered body and the ceramic sintered body may each contain impurities derived from raw materials or present as raw materials, components and impurities that may be contained in a sintering aid, a common material, and the like. Such components may be present in an amount of less than 5%.

For the presence of a crystal grain, the presence or absence of a crystal grain can be determined by observing a contrast difference due to a difference in crystal orientation in a range including a target region with a transmission electron microscope, a scanning electron microscope, a scanning ion microscope, or the like.

The crystallinity of a crystal grain can be evaluated by performing a crystal structure analysis method using X-ray diffraction or fine part X-ray diffraction in a range including a target region.

In addition, whether the target region is crystalline, non-crystalline, or has both a crystalline part and a noncrystalline part can be examined by a crystal structure analysis method using X-ray diffraction or fine X-ray diffraction.

A diffraction line from a crystalline part may be detected as a steep peak, and scattered light from a noncrystalline part may be detected as halo (continuous).

In the composite fiber of the present disclosure, at least the metal sintered body and the ceramic sintered body are adjacent to each other, and the metal sintered body that may be composed of a crystal grain of metal (or metal component) and the ceramic sintered body that may be composed of a crystal grain of ceramic (or ceramic component) form an interface having face roughness, particularly an interface having irregularities that spread two-dimensionally or three-dimensionally, the interface being formed by co-sintering, whereby stress concentration that may be generated between the metal sintered body and the ceramic sintered body can be relaxed. As a result, it is possible to inhibit interlayer peeling that may occur between the metal sintered body and the ceramic sintered body and further improve the bonding strength between the metal sintered body and the ceramic sintered body.

As a result, it is possible to improve the strength (breaking strength, in particular tensile strength or elongation at break load) of the composite fiber (increasing strength). In addition, in the composite fiber of the present disclosure, the presence of an interface having complicated irregularities that may be composed of such a crystal grain can inhibit interlayer peeling and further improve the strength of the composite fiber, and therefore can reduce the size of the composite fiber (downsizing) and improve the flexibility of the composite fiber of the present disclosure. Note that the mechanism by which the strength and flexibility of the composite fiber of the present disclosure are improved is not limited to the above theory.

In the composite fiber of the present disclosure, the tensile strength (breaking elongation load) of the whole fiber is, for example, 5 kgf/mm² or more, preferably 6 kgf/mm² or more, more preferably 10 kgf/mm² or more, still more preferably 14 kgf/mm² or more, or 20 kgf/mm² or more, particularly preferably 50 kgf/mm² or more and 400 kgf/mm² or less, and it is possible to achieve a considerably improved strength as compared with a conventional PZT fiber.

In the composite fiber of the present disclosure, the tensile strength (breaking elongation load) preferably increases in the order of ceramic sintered body < composite fiber < metal sintered body.

The composite fiber of the present disclosure has flexibility with which the composite fiber has a radius of curvature of, for example, 200 mm or less, and can exhibit more improved flexibility than a conventional PZT fiber. Here, the "radius of curvature" means a radius of curvature immediately before the composite fiber of the present disclosure is bent or broken, for example, when the composite fiber is bent by hand. In addition, it is preferable that the composite fiber of the present disclosure can maintain electrical characteristics.

The fiber size of the composite fiber of the present disclosure is, for example, 500 um or less, preferably 1 um or more and 500 um or less, with which it is possible to achieve a reduced diameter (downsizing) as compared with the conventional PZT fiber. Here, the "fiber size" of the composite fiber of the present disclosure means the largest dimension (for example, diameter) in a section in a direction perpendicular to the axial direction of the fiber.

In the composite fiber of the present disclosure, the sectional area ratio (metal/ceramic) between the metal sintered body and the ceramic sintered body is not particularly limited, and is, for example, 1/99 to 99/1, preferably 1/8 to 8/1.

In the composite fiber of the present disclosure, the weight ratio between the metal sintered body and the ceramic sintered body (metal/ceramic) is not particularly limited, and is, for example, 1/99 to 99/1, preferably 1/8 to 8/1.

Here, in the composite fiber 10 according to an embodiment of the present invention illustrated in FIG. 1, the metal sintered body 1 is positioned at the "central part" of the fiber 10 (in other words, the "central part" of the fiber 10 is composed of the metal sintered body 1). In the embodiment illustrated in FIG. 1, the ceramic sintered body 2 is positioned at an "outer part" of the fiber 10 (in other words, an "outer part" of the fiber 10 is composed of the ceramic sintered body 2). In such an embodiment, in which the "central part" of the composite fiber has a metallic property, the "central part" can be electrically connected. Note that the composite fiber of the present disclosure is not limited to the embodiment illustrated in FIG. 1.

In the present disclosure, the "central part" of a fiber means a part including a geometrical center of the fiber in a section in a direction perpendicular to the axial direction of the fiber.

The "outer part" means a part located on the outermost side of the fiber in a section in a direction perpendicular to the axial direction of the fiber.

An "intermediate part" may be further present between the "outer part" and the "central part".

In the present disclosure, the "central part", the "outer part", and the "intermediate part" may be each independently composed of a "metal sintered body" or a "ceramic sintered body". However, the "metal sintered body" and the "ceramic sintered body" are preferably positioned adjacent to each other according to the present disclosure.

In a composite fiber according to another embodiment of the present invention, the ceramic sintered body may be positioned at a central part of the composite fiber. In this case, the metal sintered body may be positioned at the outer part of the composite fiber. In such an embodiment, the outer part of the composite fiber can be electrically connected.

In a composite fiber according to still another embodiment of the present invention, a central part of the composite fiber may be composed of the metal sintered body. In this case, at least a part of an outer part of the composite fiber may be composed of the ceramic sintered body. In such an embodiment, the central part of the composite fiber can be electrically connected to the outside.

In the present disclosure, "at least a part of the outer part" means at least a part in the axial direction of the composite fiber and/or at least a part in the circumferential direction of the composite fiber. The composite fiber of the present disclosure may be composed of or covered with the outer part in a range of 0 to 100% (but not including 0%), preferably 50 to 100% in any direction.

In a composite fiber according to still another embodiment of the present invention, a central part of the composite fiber may be composed of the ceramic sintered body. In this case, at least a part of an outer part of the composite fiber may be composed of the metal sintered body. In such an embodiment, the outer part of the composite fiber can be electrically connected to the outside.

In a composite fiber according to still another embodiment of the present invention, a central part of the composite fiber may be composed of the metal sintered body. In this case, the outer part of the composite fiber may also be independently composed of the metal sintered body, and an intermediate part that may be disposed between the central part and the outer part may be composed of the ceramic sintered body. In such an embodiment, the central part and/or the outer part of the composite fiber can be electrically connected to the outside.

In any of the above embodiments, the metal sintered body and the ceramic sintered body are preferably positioned adjacent to each other. When such a positional relationship is satisfied, the composite fiber of the present disclosure can have various forms of multilayer structure.

### (Electrode structure)

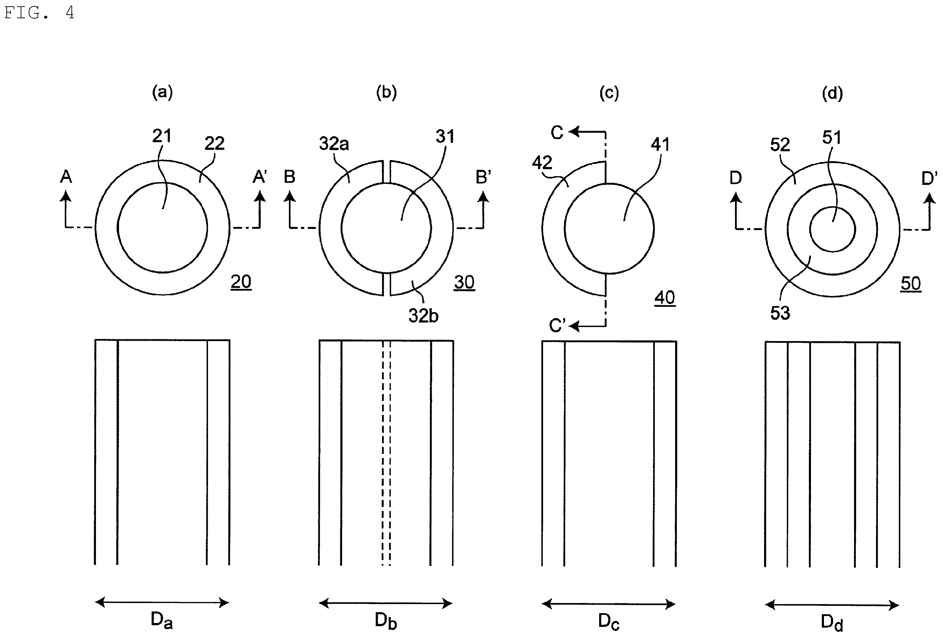

The composite fiber of the present disclosure may have, for example, an electrode structure as illustrated in FIG. 4 as another embodiment. The composite fiber of the present disclosure having an electrode structure can be used as a material for an electronic component, particularly as an electronic component element.
(a) For example, a composite fiber 20 illustrated in FIG. 4(a) has a substantially circular section and has a structure in which a central part 21 and an outer part 22 are disposed in a substantially concentric fashion. The sectional shape of the composite fiber 20 is not limited to a circular shape or a concentric shape.

In the composite fiber 20, either one of the central part 21 and the outer part 22 may be composed of either one of a "metal sintered body" and a "ceramic sintered body", and the other one of the central part 21 and the outer part 22 may be composed of the other one of a "metal sintered body" and a "ceramic sintered body". In the composite fiber 20, the "metal sintered body" and the "ceramic sintered body" are preferably positioned adjacent to each other.

A fiber size Dₐ (maximum dimension or maximum diameter) illustrated in the sectional view (axial sectional view) of FIG. 4(a) (lower side) which is a section taken along the line A-A' in FIG. 4(a) (upper side) is, for example, 500 um or less, preferably 1 um or more and 500 um or less.

(b)
A composite fiber 30 illustrated in FIG. 4(b) has a structure in which an outer part 32a having a substantially C-shaped (or substantially crescent) section and an outer part 32b having an inverted substantially C-shaped (or substantially crescent) section (hereinafter, the outer parts 32a and 32b are collectively referred to as "outer part 32") are disposed at an interval with a central part 31 having a substantially circular section. The sectional shape of the composite fiber 30 is not limited to the illustrated shape.

In the composite fiber 30, either one of the central part 31 and the outer part 32 is composed of either one of a "metal sintered body" and a "ceramic sintered body", and the other one of the central part 31 and the outer part 32 is composed of the other one of a "metal sintered body" and a "ceramic sintered body". In the composite fiber 30, the "metal sintered body" and the "ceramic sintered body" are preferably positioned adjacent to each other.

The "metal sintered body" or the "ceramic sintered body" included in the outer part 32 may be the same or different in the outer parts 32a and 32b.

A fiber size D_{b} (maximum dimension or maximum diameter) illustrated in the sectional view (axial sectional view) of FIG. 4(b) (lower side) which is a section taken along the line B-B' in FIG. 4(b) (upper side) is, for example, 500 um or less, preferably 1 um or more and 500 um or less.

(c)
A composite fiber 40 illustrated in FIG. 4(c) has a structure in which an outer part 42 having a substantially C-shaped (or substantially crescent) section is disposed in a part of a central part 41 having a substantially circular section. The sectional shape of the composite fiber 40 is not limited to the illustrated shape.

In the composite fiber 40, either one of the central part 41 and the outer part 42 is composed of either one of a "metal sintered body" and a "ceramic sintered body", and the other one of the central part 41 and the outer part 42 is composed of the other one of a "metal sintered body" and a "ceramic sintered body". In the composite fiber 40, the "metal sintered body" and the "ceramic sintered body" are preferably positioned adjacent to each other.

A fiber size D_{c} (maximum dimension or maximum diameter) illustrated in the sectional view (axial sectional view) of FIG. 4(c) (lower side) which is a section taken along the line C-C' in FIG. 4(c) (upper side) is, for example, 500 um or less, preferably 1 um or more and 500 um or less.

(d)
A composite fiber 50 illustrated in FIG. 4(d) has a substantially circular section and has a structure in which a central part 51, an outer part 52, and an intermediate part 53 disposed between the central part 51 and the outer part 52 are disposed in a substantially concentric fashion. The sectional shape of the composite fiber 50 is not limited to a circular shape or a concentric shape.

In the composite fiber 50, both the central part 51 and the outer part 52 are composed of one of a "metal sintered body" and a "ceramic sintered body", and the intermediate part 53 is composed of the other of a "metal sintered body" and a "ceramic sintered body". In the composite fiber 50, the "metal sintered body" and the "ceramic sintered body" are preferably positioned adjacent to each other.

A fiber size D_{d} (maximum dimension or maximum diameter) illustrated in the sectional view (axial sectional view) of FIG. 4(d) (lower side) which is a section taken along the line D-D' in FIG. 4(d) (upper side) is, for example, 500 um or less, preferably 1 um or more and 500 um or less.

For example, in the above-described embodiments (a) and (c), it is preferable that the "central part" of the fiber be composed of a "metal sintered body" and the "outer part" of the fiber be composed of a "ceramic sintered body". Such a configuration enables the central part of the fiber to function as an electrode.

For example, in the above-described embodiments (b) and (c), it is preferable that the "central part" of the fiber be composed of a "ceramic sintered body" and the "outer part" of the fiber be composed of a "metal sintered body". Such a configuration enables the outer part of the fiber to function as an electrode.

For example, in the above-described embodiment (d), it is preferable that the "central part" of the fiber be composed of a "metal sintered body", the "outer part" of the fiber be also independently composed of a "metal sintered body", and the "intermediate part" be composed of a "ceramic sintered body". The "metal sintered body" of the "central part" and the "outer part" is more preferably the same. Such a configuration enables the central part and/or the outer part of the fiber to function as an electrode.

### (Other embodiments)

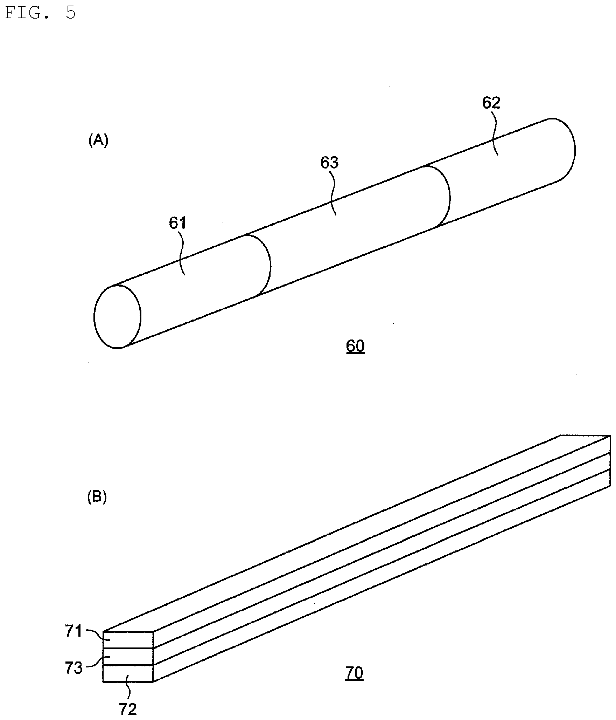

As other embodiments, the composite fiber of the present disclosure includes, for example, a form in which a metal sintered body and a ceramic sintered body are adjacent to each other in the axial direction of the fiber as illustrated in FIG. 5(A) and a form in which a metal sintered body and a ceramic sintered body are adjacent to each other in a sandwich structure as illustrated in FIG. 5 (B) .

In the embodiment illustrated in FIG. 5(A), for example, it is preferable that a first end 61 of a composite fiber 60 in the axial direction be composed of a "metal sintered body", a second end 62 opposite to the first end be also independently composed of a "metal sintered body", and a connecting part 63 that may be disposed between the first end 61 and the second end 62 be composed of a "ceramic sintered body". Such a configuration enables both ends (61, 62) of the fiber to function as electrodes.

Further, the first end 61 and the second end 62 may be each independently composed of a "ceramic sintered body", and the connecting part 63 may be composed of a "metal sintered body".

Alternatively, in the above-described aspect, the connecting part 63 may have a configuration in which a "metal sintered body" and a "ceramic sintered body" may alternately continue.

In the embodiment illustrated in FIG. 5(B), for example, it is preferable that, in a section in an axial direction or a direction perpendicular to the axial direction of a composite fiber 70, a middle part (middle layer) 73 of the composite fiber be composed of a "metal sintered body", and an upper part (upper layer) 71 and a lower part (lower layer) 72 of the composite fiber 70 be each independently composed of a "ceramic sintered body". Such a configuration enables the middle part (middle layer) 73 of the fiber to function as an electrode. In the illustrated embodiment, the section of the fiber is substantially rectangular (quadrangular) but is not limited to such a sectional shape.

Alternatively, the middle part (middle layer) 73 of the composite fiber 70 may be composed of a "ceramic sintered body", and the upper part (upper layer) 71 and the lower part (lower layer) 72 of the composite fiber 70 may be each independently composed of a "metal sintered body". Such a configuration enables the upper and lower parts (upper and lower layers) (71, 72) of the fiber to function as electrodes.

The composite fiber of the present disclosure is not limited to the above-described embodiments. Hereinafter, a method for producing a composite fiber of the present disclosure will be briefly described.

### (Method for producing composite fiber of the present disclosure)

In the composite fiber of the present disclosure, it is preferable that at least the "metal sintered body" and the "ceramic sintered body" be integrally formed or produced adjacent to each other by, for example, co-sintering. Forming the "metal sintered body" and the "ceramic sintered body" integrally adjacent to each other enables an interface to form, especially an interface having complex irregularities that may be composed of a crystal grain of the metal component and a crystal grain of the ceramic component, particularly an interface having the above-described face roughness.

The method for producing the composite fiber of the present disclosure is not particularly limited, and the composite fiber of the present disclosure can be properly produced by applying a conventionally known ceramic firing technique or the like.

For example, a composite fiber in which a metal sintered body and a ceramic sintered body are integrally formed adjacent to each other can be produced by preparing a paste of a raw material containing the above-described metal component (metal element) together with a sintering aid, a co-material, a binder resin, a solvent, a dispersant, a plasticizer and the like as necessary and a paste of a raw material containing the above-described ceramic component (ceramic element) together with a sintering aid, a co-material, a binder resin, a solvent, a dispersant, a plasticizer and the like as necessary, and molding and firing the pastes together. At this time, each paste may be molded into a desired shape using, for example, a multiple nozzle (composite spinning nozzle such as double nozzle or triple nozzle), a molding die, or the like.

For example, when a paste for metal sintered body and a paste for ceramic sintered body are formed into fibers using a multiple nozzle such as a double nozzle, other materials such as "metal not composed of a crystal grain" and/or "ceramic not composed of a crystal grain" may be used as a core part or a core.

The "metal not composed of a crystal grain" that may be used as a core part in the composite fiber of the present disclosure is, for example, a metal or alloy, and means a metal or alloy formed or produced in advance separately from the "metal sintered body" and the "ceramic sintered body" described above. In other words, it means a metal or alloy formed or produced before co-sintering of the "metal sintered body" and the "ceramic sintered body" described above. Thus, a metal or alloy that may be formed or produced by sintering at the same time as the co-sintering of the "metal sintered body" and the "ceramic sintered body" does not fall into the "metal not composed of a crystal grain".

As the "metal not composed of a crystal grain" that may be used as the core part, for example, a commercially available metal or alloy wire, particularly a metal or alloy wire produced by rolling or the like may be used. More specifically, a nickel wire, a copper wire, or the like may be used.

The "ceramic not composed of a crystal grain" that may be used as a core part in the composite fiber of the present disclosure means, for example, a ceramic formed or produced in advance separately from the "metal sintered body" and the "ceramic sintered body" described above. In other words, it means a ceramic formed or produced before co-sintering of the "metal sintered body" and the "ceramic sintered body" described above. Thus, a ceramic that may be formed or produced by sintering at the same time as the co-sintering of the "metal sintered body" and the "ceramic sintered body" does not fall into the "ceramic not composed of a crystal grain".

As the "ceramic not composed of a crystal grain", for example, a commercially available ceramic fiber or the like may be used. More specifically, a glass fiber or the like may be used.

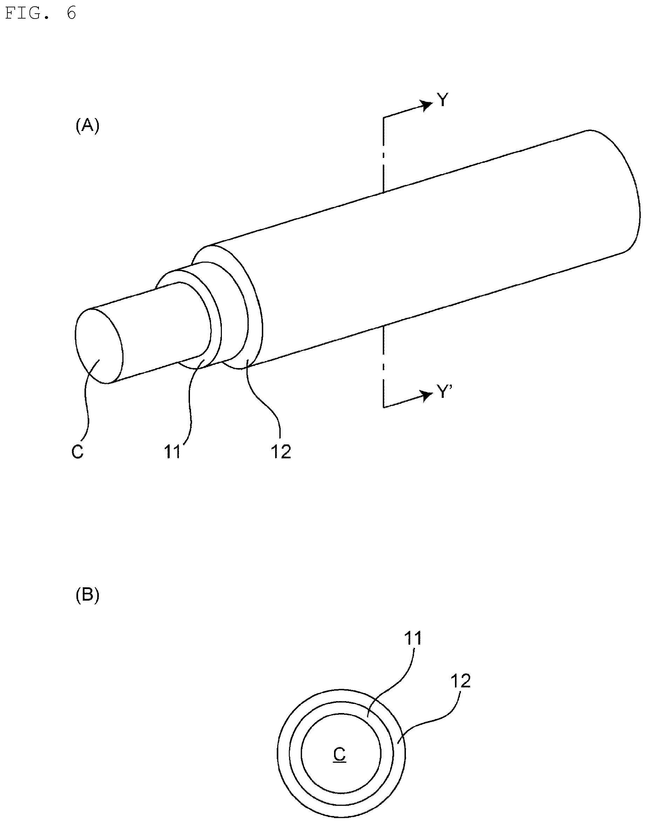

For example, as illustrated in FIG. 6(A), the composite fiber of the present disclosure may include a core part (or core) (C), a first layer (11) covering the core part (C), and a second layer (12) covering the first layer (11).

More specifically, as illustrated in FIG. 6(A), the composite fiber of the present disclosure may include the core part (C), the first layer (11) covering the core part (C), and the second layer (12) covering the first layer (11), in which the core part (C) may include "a metal not composed of a crystal grain", the first layer (11) may include "a metal sintered body", specifically, the above-described metal sintered body composed of a crystal grain of metal, and the second layer (12) may include "a ceramic sintered body", specifically, the above-described ceramic sintered body composed of a crystal grain of ceramic.

In such a composite fiber, the first layer that may be composed of a "metal sintered body" and the second layer that may be composed of a "ceramic sintered body" may be both composed of crystal grains, so that the layers form an interface having the above-described face roughness and bind to each other to improve the strength of the fiber. The core part (C) may further contain a "metal not composed of a crystal grain", more specifically, a metal wire, to further improve the strength of the fiber. At this time, the first layer may be composed of a "metal sintered body" to further improve the bonding force with the core part (C) and significantly improve the strength of the composite fiber.

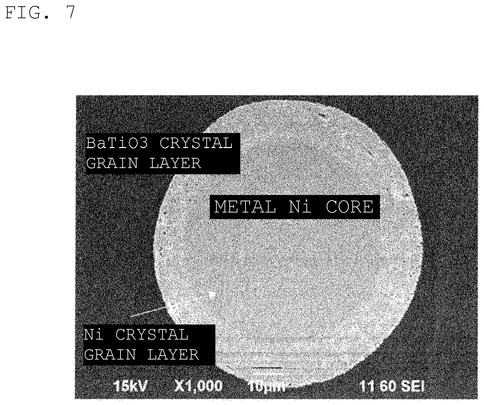

As an example, a composite fiber in which a nickel wire (metal Ni core) is used as the core part, the first layer is a nickel (Ni) crystal grain layer, and the second layer is a barium titanate (BaTiO₃) crystal grain layer is illustrated in FIG. 7 (see Example 13).

As illustrated in FIG. 6(A) for example, the composite fiber of the present disclosure may include the core part (C), the first layer (11) covering the core part (C), and the second layer (12) covering the first layer (11), in which the core part (C) may include a "ceramic not composed of a crystal grain", the first layer (11) may include a "ceramic sintered body", specifically, the above-described ceramic sintered body composed of a crystal grain of ceramic, and the second layer (12) may include a "metal sintered body", specifically, the above-described metal sintered body composed of a crystal grain of metal.

In such a composite fiber, the first layer that may be composed of a "ceramic sintered body" and the second layer that is composed of a "metal sintered body" may be both composed of crystal grains, so that the layers form an interface having the above-described face roughness and bind to each other to improve the strength of the fiber. The core part (C) may further contain a "ceramic not composed of a crystal grain", more specifically, a ceramic fiber, to further improve the strength of the fiber. At this time, the first layer may be composed of a "ceramic sintered body" to further improve the bonding force with the core part (C) and significantly improve the strength of the composite fiber.

The composite fiber having such a structure can be produced, for example, by shaping a paste for metal sintered body and a paste for ceramic sintered body concentrically with the core part (C) as a core using a double nozzle in a conventional apparatus used in the extrusion molding method illustrated in FIG. 13.

In the composite fiber of the present disclosure, for example, the second layer (12) illustrated in FIG. 6 may be a "metal not composed of a crystal grain" and/or a "ceramic not composed of a crystal grain".

When the second layer (12) is a "metal not composed of a crystal grain", the second layer (12) may be a plating layer, a deposited film, or a sputtered film of metal or alloy.

When the second layer (12) is a "ceramic not composed of a crystal grain", the second layer (12) may be a coating layer, a deposited film, or a sputtered film of ceramic.

As illustrated in FIG. 6(A) for example, the composite fiber of the present disclosure may include the core part (C), the first layer (11) covering the core part (C), and the second layer (12) covering the first layer (11), in which the core part (C) may include a "ceramic sintered body", specifically, the above-described ceramic sintered body composed of a crystal grain of ceramic, the first layer (11) may include a "metal sintered body", specifically, the above-described metal sintered body composed of a crystal grain of metal, and the second layer (12) may include a "metal not composed of a crystal grain".

In such a composite fiber, the core part that may be composed of a "ceramic sintered body" and the first layer that may be composed of a "metal sintered body" may be both composed of crystal grains, so that they form an interface having the above-described face roughness and bind to each other to improve the strength of the fiber. The second layer (12) may further contain a "metal not composed of a crystal grain" to further improve the strength of the fiber. At this time, the first layer may be composed of a "metal sintered body" to further improve the bonding force with the second layer (12) and significantly improve the strength of the composite fiber.

As illustrated in FIG. 6(A) for example, the composite fiber of the present disclosure may include the core part (C), the first layer (11) covering the core part (C), and the second layer (12) covering the first layer (11), in which the core part (C) may include a "metal sintered body", specifically, the above-described metal sintered body composed of a crystal grain of metal, the first layer (11) may include a "ceramic sintered body", specifically, the above-described ceramic sintered body composed of a crystal grain of ceramic, and the second layer (12) may include a "ceramic not composed of a crystal grain".

In such a composite fiber, the core part that may be composed of a "metal sintered body" and the first layer that may be composed of a "ceramic sintered body" may be both composed of crystal grains, so that they form an interface having the above-described face roughness and bind to each other to improve the strength of the fiber. The second layer (12) may further contain a "ceramic not composed of a crystal grain" to further improve the strength of the fiber. At this time, the first layer may be composed of a "ceramic sintered body" to further improve the bonding force with the second layer (12) and significantly improve the strength of the composite fiber.

The ratio of the thicknesses of the core part (C), the first layer (11), and the second layer (12) is not particularly limited, and may be appropriately determined according to a desired application. The total thickness or diameter (maximum dimension or maximum diameter) of the composite fiber is, for example, 500 um or less, preferably 1 um or more and 500 um or less.

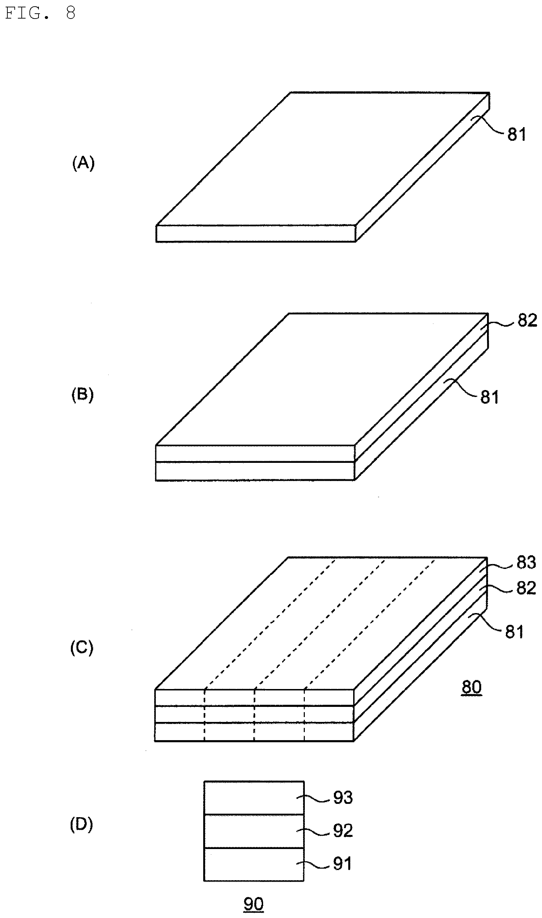

The composite fiber of the present disclosure may also be produced by a stacking technique, for example a printing method such as a screen-printing method, a green sheet method using a green sheet, or a combined method thereof. When such a stacking technique is used, the composite fiber of the present disclosure may be produced by appropriately fiberizing a stacked body before firing or after firing by cutting (see, for example, FIG. 8).

The method for producing the composite fiber of the present disclosure is not limited to the above method. Hereinafter, the composite fiber of the present disclosure will be described in more detail with reference to Examples.

### EXAMPLES

### Examples 1 to 10

### (1) Preparation of paste for metal sintered body

The paste for metal sintered body includes a Ni powder, a perovskite oxide containing Ba and Ti as common materials, a polycarboxylic acid dispersant, a binder resin, and an organic solvent. The Ni powder had an average particle size of 0.2 um. The perovskite oxide containing Ba and Ti had an average particle size of 30 nm. As the binder resin, for example, a resin solution obtained by dissolving a resin in butyl carbitol is used. As the resin dissolved in butyl carbitol, for example, ethyl cellulose, cellulose acetate butyrate, or the like is used. In the preparation of the paste for metal sintered body, 50 parts by weight of the Ni powder, 5 parts by weight of the perovskite oxide containing Ba and Ti as common materials, a resin solution obtained by dissolving 10 parts by weight of ethyl cellulose in butyl carbitol, 1 part by weight of a polycarboxylic acid dispersant, and butyl carbitol as the balance were mixed, and the paste for metal sintered body was prepared with a ball mill.

### (2) Preparation of paste for ceramic sintered body

The paste for ceramic sintered body includes a perovskite oxide containing Ba and Ti, a polyvinyl butyral-based binder resin, a plasticizer, and an organic solvent such as toluene. The perovskite oxide containing Ba and Ti had an average particle size of 100 nm. In the preparation of the paste for ceramic sintered body, 90 parts by weight of the perovskite oxide containing Ba and Ti, 10 parts by weight of a polyvinyl butyral-based binder resin, a plasticizer, and toluene were mixed, and the paste for ceramic sintered body was prepared with a ball mill.

As schematically illustrated in FIG. 8, the paste for ceramic sintered body was applied to a support substrate (not illustrated) and dried to produce a first ceramic sintered body green sheet 81 (FIG. 8(A)).

The paste for metal sintered body was stacked on the first ceramic sintered body green sheet 81 by printing to form a metal sintered body print layer 82 (FIG. 8(B)).

In the same manner as in the first ceramic sintered body green sheet 81, a second ceramic sintered body green sheet 83 was made from the paste for ceramic sintered body, peeled off from a support substrate, and then stacked on the metal sintered body print layer 82 and pressure-bonded to produce a stacked body 80 (FIG. 8(C)).

Next, the stacked body 80 was cut into an elongated shape along a broken line schematically illustrated in FIG. 8(C) for example, to produce a "composite fiber precursor".

The thicknesses of the first ceramic sintered body green sheet 81, the metal sintered body print layer 82, and the second ceramic sintered body green sheet 83 were as shown in Table 1 below (unit: um).

**[Table 1]**

| Example | First ceramic sintered body green sheet | Metal sintered body print layer | Second ceramic sintered body green sheet |
|---|---|---|---|
| 1 | 9.1 | 20.1 | 9.1 |
| 2 | 3.2 | 4.0 | 3.2 |
| 3 | 3.2 | 10.3 | 3.2 |
| 4 | 3.2 | 20.0 | 3.2 |
| 5 | 3.2 | 40.5 | 3.2 |
| 6 | 14.9 | 20.1 | 14.9 |
| 7 | 30.1 | 20.1 | 30.1 |
| 8 | 9.1 | 4.0 | 9.1 |
| 9 | 9.1 | 10.3 | 9.1 |
| 10 | 30.1 | 40.5 | 30.1 |

### (Firing Step)

The "composite fiber precursor" was fired under the following conditions to produce a composite fiber as a fiber body in which a "metal sintered body" and a "ceramic sintered body" were adjacent to each other.

### Firing conditions

After a degreasing treatment was performed under the conditions of 400°C and 10 hours in a nitrogen atmosphere, firing was performed under the conditions of a top temperature of 1200°C and an oxygen partial pressure of 10⁻⁹ to 10⁻¹⁰ MPa in a nitrogen-hydrogen-water vapor mixed atmosphere.

FIG. 8(D) schematically illustrates a section (section in the axial direction) of the composite fiber produced in Example 1. More specifically, FIG. 8(D) schematically illustrates a structure in which a nickel metal (Ni) (92) (central part in the section) formed as a metal sintered body is sandwiched between barium titanate (BaTiO₃) (BT) (91, 93) (upper and lower parts in the section) formed as ceramic sintered bodies, and the metal sintered body and the ceramic sintered bodies are adjacent to each other.

### (Section observation)

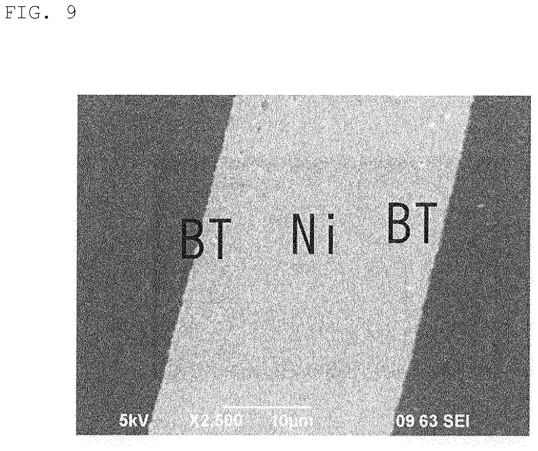

A section (section in the axial direction) of the composite fiber of Example 1 produced as described above was observed with an electron microscope (JCM-5700 manufactured by JEOL Ltd.). FIG. 9 is an electron micrograph of the section of the composite fiber (5.0 kV, 2500 magnifications).

In the electron micrograph of FIG. 9, the thickness of Ni was 15.6 um, and the thickness of BaTiO₃ (BT) was 6.0 um (Table 2). The metal sintered body (Ni) and the ceramic sintered bodies (BaTiO₃) were not peeled off, and were in a bonded state in close contact with each other.

The thickness of Ni and the thickness of BaTiO₃ of Examples 2 to 10 are shown in Table 2 below (unit: um).

**[Table 2]**

| Example | Barium titanate layer (91) | Nickel layer (92) | Barium titanate layer (93) |
|---|---|---|---|
| 1 | 6.0 | 15.6 | 6.0 |
| 2 | 2.1 | 3.0 | 2.1 |
| 3 | 2.1 | 7.6 | 2.1 |
| 4 | 2.1 | 15.5 | 2.1 |
| 5 | 2.1 | 30.5 | 2.1 |
| 6 | 9.9 | 15.1 | 9.9 |
| 7 | 20.4 | 15.0 | 20.4 |
| 8 | 6.0 | 3.0 | 6.0 |
| 9 | 5.9 | 7.5 | 5.9 |
| 10 | 19.8 | 30.5 | 19.8 |

### (Strength measurement)

The tensile strength of the composite fibers produced in Examples 1 to 10 was measured with a strength tester (MST-1 manufactured by Shimadzu Corporation). The radius of curvature of the composite fibers produced in Examples 1 to 10 was evaluated. Table 3 below shows the evaluation results of the tensile strength and the radius of curvature of the composite fibers produced in Examples 1 to 10.

**[Table 3]**

| Example | Tensile strength [kgf/mm²] | Radius of curvature [mm] |
|---|---|---|
| 1 | 21.9 | 5 |
| 2 | 15.1 | 3 |
| 3 | 20.9 | 3 |
| 4 | 28.5 | 3 |
| 5 | 29.5 | 3 |
| 6 | 14.3 | 10 |
| 7 | 11.2 | 15 |
| 8 | 12.2 | 5 |
| 9 | 16.3 | 5 |
| 10 | 18.1 | 15 |

In each of the composite fibers of Examples 1 to 10, the tensile strength was 10 kgf/mm² or more, and the radius of curvature was 15 mm or less.

### Comparative Example 1 (composite fiber including nickel foil)

### (1) Preparation of nickel foil

A nickel foil having a thickness of 15 um was obtained from The Nilaco Corporation instead of the paste for metal sintered body.

### (2) Preparation of paste for ceramic sintered body

A paste for ceramic sintered body was prepared in the same manner as in Examples 1 to 10.

As schematically illustrated in FIG. 8, the paste for ceramic sintered body was applied to a support substrate (not illustrated) and dried to produce the first ceramic sintered body green sheet 81 (FIG. 8(A)).

The nickel foil was stacked on the first ceramic sintered body green sheet 81 instead of the metal sintered body print layer 82 (FIG. 8(B)).

In the same manner as in the first ceramic sintered body green sheet 81, the second ceramic sintered body green sheet 83 was made from the paste for ceramic sintered body, peeled from the support substrate, and then stacked on the nickel foil and pressure-bonded to produce the stacked body 80 (FIG. 8(C)).

Next, the stacked body 80 was cut into an elongated shape along a broken line schematically illustrated in FIG. 8(C) for example, to produce a "composite fiber precursor".

The thicknesses of the first ceramic sintered body green sheet 81, the nickel layer 82, and the second ceramic sintered body green sheet 83 were as shown in Table 4 below (unit: um).

**[Table 4]**

| Comparative Example | First ceramic sintered body green sheet (81) | Nickel layer (82) | Second ceramic sintered body green sheet (83) |
|---|---|---|---|
| 1 | 9.1 | 15.0 | 9.1 |

### (Firing Step)

The "composite fiber precursor" was fired under the following conditions to produce a composite fiber as a fiber body in which a "nickel layer (metal foil layer)" and a "ceramic sintered body" were adjacent to each other (that is, a fiber body having a three-layer structure in which a "ceramic sintered body (BT)", a "Ni layer (metal foil layer)", and a "ceramic sintered body (BT)" are adjacent to each other.).

### Firing conditions

After a degreasing treatment was performed under the conditions of 400°C and 10 hours in a nitrogen atmosphere, firing was performed under the conditions of a top temperature of 1200°C and an oxygen partial pressure of 10⁻⁹ to 10⁻¹⁰ MPa in a nitrogen-hydrogen-water vapor mixed atmosphere.

### (Section observation)

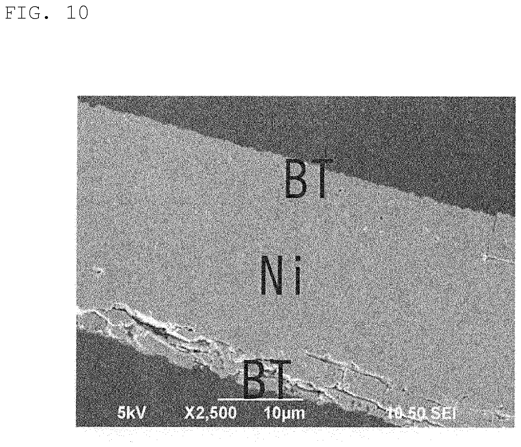

A section (section in the axial direction) of the composite fiber produced as described above was observed with an electron microscope (JCM-5700 manufactured by JEOL Ltd.) . FIG. 10 is an electron micrograph of the section of the composite fiber (5.0 kV, 2500 magnifications).

**[Table 5]**

| Comparative Example | Barium titanate layer (91) | Nickel layer (92) | Barium titanate layer (93) |
|---|---|---|---|
| 1 | 6.0 | 15.0 | 6.0 |

As shown in FIG. 10, the BaTiO₃ (BT) layer was broken by stress applied to the BaTiO₃ layer due to a difference in thermal expansion coefficient. Peeling of the Ni-BaTiO₃ (BT) layer also occurred. From these results, it was found that the composite fiber of Comparative Example 1 does not physically function as a piezoelectric fiber.

### (Strength measurement)

The tensile strength of the composite fiber produced in Comparative Example 1 was measured with a strength tester (MST-1 manufactured by Shimadzu Corporation). The radius of curvature of the composite fiber produced in Comparative Example 1 was evaluated. Table 6 below shows the evaluation results of the tensile strength and the radius of curvature of the composite fiber of Comparative Example 1.

**[Table 6]**

| Comparative Example | Tensile strength [kgf/mm²] | Radius of curvature [mm] |
|---|---|---|
| 1 | 13.7 | 5 |

From the results shown in Table 6, it was found that the composite fiber of Comparative Example 1 had only a tensile strength of about 60% as compared with the composite fiber of Example 1.

Example 11A paste for metal sintered body and a paste for ceramic sintered body were used in the same manner as in Example 1 to produce a composite fiber precursor having a circular section in which the paste for metal sintered body and the paste for ceramic sintered body were concentrically disposed using a double nozzle (central part: paste for metal sintered body (Ni), outer part; paste for ceramic sintered body (BT), sectional area ratio (metal/ceramic): 1/1) .

Next, the composite fiber precursor was fired under the same firing conditions as in Example 1 to produce a composite fiber having a circular section (fiber size: 90 um) (central part: metal sintered body (Ni), outer part; ceramic sintered body (BT)).

The strength of the composite fiber produced in Example 11 was measured in the same manner as in Example 1.

The tensile strength of the composite fiber produced in Example 11 was 19.1 kgf/mm².

The radius of curvature of the composite fiber produced in Example 11 was 5 mm.

Example 12A composite fiber precursor having a circular section in which the following paste for metal sintered body and paste for ceramic sintered body were concentrically disposed using a double nozzle (central part: metal sintered body paste (Cu), outer part; paste for ceramic sintered body (BNT), sectional area ratio (metal (Cu)/ceramic (BNT)): 1/1) was produced in the same manner as in Example 11 except that the following paste for metal sintered body and paste for ceramic sintered body were used.
(1) The metal sintered body is composed of a Cu powder, a perovskite oxide containing Bi, Na, and Ti as common materials, a polycarboxylic acid dispersant, a binder resin, and an organic solvent. The Cu powder had an average particle size of 0.2 um. The perovskite oxide containing Bi, Na, and Ti had an average particle size of 30 nm. As the binder resin, for example, a resin solution obtained by dissolving a resin in butyl carbitol is used. As the resin dissolved in butyl carbitol, for example, ethyl cellulose, cellulose acetate butyrate, or the like is used. In the preparation of the paste for metal sintered body, 50 parts by weight of the Cu powder, 5 parts by weight of the perovskite oxide containing Bi, Na and Ti as common materials, a resin solution obtained by dissolving 10 parts by weight of ethyl cellulose in butyl carbitol, 1 part by weight of a polycarboxylic acid dispersant, and butyl carbitol as the balance were mixed, and the paste for metal sintered body was prepared with a ball mill.
(2) Preparation of paste for ceramic sintered body
   The paste for ceramic sintered body is composed of a perovskite oxide containing Bi, Na, and Ti, a polyvinyl butyral-based binder resin, a plasticizer, and an organic solvent such as toluene. The perovskite oxide containing Bi, Na, and Ti had an average particle size of 100 nm. In the preparation of the paste for ceramic sintered body, 90 parts by weight of the perovskite oxide containing Bi, Na, and Ti, 10 parts by weight of a polyvinyl butyral-based binder resin, a plasticizer, and toluene were mixed, and the paste for ceramic sintered body was prepared with a ball mill.

Next, the composite fiber precursor was fired under the same firing conditions as in Example 1 to produce a composite fiber having a circular section (fiber size: 100 µm) (central part: metal sintered body (Cu), outer part; ceramic sintered body (bismuth sodium titanate) (BNT)).

The strength of the composite fiber produced in Example 12 was measured in the same manner as in Example 1.

The tensile strength of the composite fiber produced in Example 12 was 15.4 kgf/mm².

The radius of curvature of the composite fiber produced in Example 12 was 5 mm.

### Example 13

A composite fiber precursor having a circular section in which a paste for metal sintered body (Ni) and a paste for ceramic sintered body (BT) were concentrically disposed (core part: Ni wire (wire), first layer (inner part): paste for metal sintered body (Ni), second layer (outer part); paste for ceramic sintered body (BT), sectional area ratio (Ni wire/Ni layer/BT layer): 0.70/0.30/1.0) was produced using the paste for metal sintered body (Ni), the paste for ceramic sintered body (BT), and the nickel wire (wire) (diameter: 50 um) prepared in Example 1, with a wire guide for passing through the nickel wire (wire) in the same manner as in the conventional technique (see FIG. 13) (however, a double nozzle was used in this Example).

Next, the composite fiber precursor was fired under the same firing conditions as in Example 1 to produce a composite fiber having a circular section (fiber size: 88 µm) (core part: metal Ni, first layer (inner part): metal sintered body (Ni), second layer (outer part); ceramic sintered body (BT)).

The strength of the composite fiber produced in Example 13 was measured in the same manner as in Example 1.

The tensile strength of the composite fiber produced in Example 13 was 19.8 kgf/mm².

The radius of curvature of the composite fiber produced in Example 13 was 5 mm.

### (Section observation)

A section (section in the direction perpendicular to the axial direction (axial section)) of the composite fiber produced in Example 13 was observed with an electron microscope (JCM-5700 manufactured by JEOL Ltd.). FIG. 7 is an electron micrograph of the section of the composite fiber (5.0 kV, 2500 magnifications).

It was found that the composite fiber of Example 13 had no interlayer peeling or cracks as shown in FIG. 7. From these results, it was found that the composite fiber of Example 13 has high tensile strength and functions as a piezoelectric fiber.

### Comparative Example 2

A composite fiber in which a "Cu layer (metal foil layer)" and a "ceramic sintered body (BNT)" were adjacent to each other, that is, a fiber body having a three-layer structure in which a "ceramic sintered body (BNT)", a "Cu layer (metal foil layer)", and a "ceramic sintered body (BNT)" were adjacent to each other was produced in the same manner as in Comparative Example 1 except that a copper foil (manufactured by The Nilaco Corporation) having a thickness of 15 um and the paste for ceramic sintered body prepared in Example 12 were used.

The strength of the composite fiber produced in Comparative Example 2 was measured in the same manner as in Example 1.

The tensile strength of the composite fiber produced in Comparative Example 2 was 6.0 kgf/mm².

The radius of curvature of the composite fiber produced in Comparative Example 2 was 10 mm.

In the composite fiber produced in Comparative Example 2, the BNT layer was broken by stress applied to the BNT layer due to a difference in thermal expansion coefficient as in the composite fiber produced in Comparative Example 1. In addition, peeling of the BMT layer occurred. From these results, it was found that the composite fiber of Comparative Example 2 does not function as a piezoelectric fiber.

### (Line roughness determination)

The line roughness of the interface between the metal sintered body and the ceramic sintered body of the composite fibers produced in Example 3 and Comparative Example 1 was measured.

Sample sections of the composite fibers produced in Example 3 and Comparative Example 1 were polished, and then subjected to SEM observation. A section where the interface between the adjacent metal sintered body (Ni) and ceramic sintered body (BT) can be observed was observed by SEM (15.0 kV, 5000 magnifications). Three visual fields in which the interface can be checked were randomly extracted from the SEM image. With image analysis software (Mitani Corporation, WinROOF), a straight line connecting two intersections between an end surface of the extracted visual field image and the interface between the metal sintered body and the ceramic sintered body was defined as a center line, and the distance between the actual boundary and the center line was measured at 30 points at equal intervals along the center line. The average value and standard deviation of these distances were used to evaluate the line roughness. The results are shown in Table 7 below.

**[Table 7]**

| Evaluation sample | Line roughness | |
|---|---|---|
| | Average value (nm) | Standard deviation (SD) |
| Example 3 - visual field 1 | 193 | 100 |
| Example 3 - visual field 2 | 159 | 114 |
| Example 3 - visual field 3 | 109 | 65 |
| Comparative Example 1 - visual field 1 | 63 | 36 |
| Comparative Example 1 - visual field 2 | 55 | 21 |
| Comparative Example 1 - visual field 3 | 52 | 16 |

The composite fiber of the present disclosure is not limited to those exemplified in the above Examples.

### INDUSTRIAL APPLICABILITY

The composite fiber of the present disclosure can be used in a sensor used in a structure such as a building, an automobile, a ship, or an airplane, particularly in a vibration sensor, an actuator, or the like. The composite fiber of the present disclosure can also be used as an electronic component element.

### DESCRIPTION OF REFERENCE SYMBOLS

1: Metal sintered body
2: Ceramic sintered body
3: Interface
10, 20, 30, 40, 50, 60, 70: Composite fiber
11: First layer
12: Second layer
C: Core part/Core
21, 31, 41, 51: Central part
22, 32, 42, 52: Outer part
53: Intermediate part
61: First end
62: Second end
63: Connecting part
71: Upper part
72: Lower part
73: Middle part
80: Stacked body
81: First ceramic sintered body green sheet
82: Metal sintered body print layer
83: Second ceramic sintered body green sheet
90: Composite fiber (section)
91: Barium titanate (BaTiO₃) (BT)
92: Nickel (Ni)
93: Barium titanate (BaTiO₃) (BT)
100: PZT fiber
101: Metal wire/Metal thin wire
102: PZT thin layer/PZT film
103: Nozzle
104: Wire guide
105: PZT paste
200: Smart board
201: Carbon fiber reinforced plastic (CFRP) prepreg
202: Structure
300: PZT fiber
301: Metal thin wire
302: PZT film

## Claims

1. A composite fiber comprising at least a metal sintered body and a ceramic sintered body, wherein the metal sintered body and the ceramic sintered body are adjacent to each other to form a fiber body.

2. The composite fiber according to claim 1, wherein the metal sintered body and the ceramic sintered body form an interface, and the interface has a face roughness.

3. The composite fiber according to claim 2, wherein the interface is composed of crystal grains.

4. The composite fiber according to any one of claims 1 to 3, wherein the metal sintered body is composed of a crystal grain of metal, and the ceramic sintered body is composed of a crystal grain of ceramic.

5. The composite fiber according to claim 4, wherein the crystal grain constituting the metal sintered body and the crystal grain constituting the ceramic sintered body form an interface.

6. The composite fiber according to claim 4 or 5, wherein the crystal grain constituting the metal sintered body is a crystal grain formed through crystal growth of metal, and the crystal grain constituting the ceramic sintered body is a crystal grain formed through crystal growth of ceramic.

7. The composite fiber according to claim 2, wherein the interface has no gap in a sectional view of the composite fiber.

8. The composite fiber according to claim 2, wherein the interface has the face roughness defined by a line roughness of the composite fiber in a sectional view.

9. The composite fiber according to any one of claims 1 to 8, wherein the metal sintered body is positioned at a central part of the composite fiber.

10. The composite fiber according to any one of claims 1 to 8, wherein the ceramic sintered body is positioned at a central part of the composite fiber.

11. The composite fiber according to any one of claims 1 to 8, wherein a central part of the composite fiber is composed of the metal sintered body, and at least a part of an outer part of the composite fiber is composed of the ceramic sintered body.

12. The composite fiber according to any one of claims 1 to 8, wherein a central part of the composite fiber is composed of the ceramic sintered body, and at least a part of an outer part of the composite fiber is composed of the metal sintered body.

13. The composite fiber according to any one of claims 1 to 8, wherein a central part of the composite fiber is composed of the metal sintered body, an outer part of the composite fiber is also independently composed of the metal sintered body, and an intermediate part disposed between the central part and the outer part is composed of the ceramic sintered body.

14. The composite fiber according to any one of claims 1 to 8, wherein a first end of the composite fiber in an axial direction is composed of the metal sintered body, a second end opposite to the first end is also independently composed of the metal sintered body, and a connecting part disposed between the first end and the second end is composed of the ceramic sintered body.

15. The composite fiber according to any one of claims 1 to 8, wherein in a section of the composite fiber in an axial direction or a direction perpendicular to the axial direction, a middle part of the composite fiber is composed of the metal sintered body, and an upper part and a lower part of the composite fiber are each independently composed of the ceramic sintered body, or the middle part of the composite fiber is composed of the ceramic sintered body, and the upper part and the lower part of the composite fiber are each independently composed of the metal sintered body.

16. The composite fiber according to any one of claims 4 to 6, wherein the composite fiber includes a core part, a first layer covering the core part, and a second layer covering the first layer, the first layer includes the metal sintered body composed of the crystal grain of metal, the second layer includes the ceramic sintered body composed of the crystal grain of ceramic, and the core part includes a metal not composed of a crystal grain.

17. The composite fiber according to any one of claims 4 to 6, wherein the composite fiber includes a core part, a first layer covering the core part, and a second layer covering the first layer, the first layer includes the ceramic sintered body composed of the crystal grain of ceramic, the second layer includes the metal sintered body composed of the crystal grain of metal, and the core part includes a ceramic not composed of a crystal grain.

18. The composite fiber according to any one of claims 4 to 6, wherein the composite fiber includes a core part, a first layer covering the core part, and a second layer covering the first layer, the core part includes the ceramic sintered body composed of the crystal grain of ceramic, the first layer includes the metal sintered body composed of the crystal grain of metal, and the second layer includes a metal not composed of a crystal grain.

19. The composite fiber according to any one of claims 4 to 6, wherein the composite fiber includes a core part, a first layer covering the core part, and a second layer covering the first layer, the core part includes the metal sintered body composed of the crystal grain of metal, the first layer includes the ceramic sintered body composed of the crystal grain of ceramic, and the second layer includes a ceramic not composed of a crystal grain.

20. The composite fiber according to any one of claims 1 to 19, wherein a metal component constituting the metal sintered body is composed of at least one selected from the group consisting of silver (Ag), palladium (Pd), copper (Cu), aluminum (Al), chromium (Cr), titanium (Ti), platinum (Pt), iron (Fe), and nickel (Ni).

21. The composite fiber according to any one of claims 1 to 20, wherein the metal sintered body is a nickel metal simple substance or a copper metal simple substance.

22. The composite fiber according to any one of claims 1 to 21, wherein a ceramic component constituting the ceramic sintered body is composed of at least one selected from the group consisting of lithium (Li), sodium (Na), potassium (K), magnesium (Mg), calcium (Ca), strontium (Sr), barium (Ba), yttrium (Y), zirconium (Zr), titanium (Ti), vanadium (V), chromium (Cr), manganese (Mn), iron (Fe), cobalt (Co), nickel (Ni), copper (Cu), zinc (Zn), boron (B), aluminum (Al), silicon (Si), indium (In), tin (Sn), antimony (Sb), barium (Ba), tantalum (Ta), tungsten (W), lead (Pb), bismuth (Bi), lanthanum (La), cesium (Ce), neodymium (Nd), samarium (Sm), gadolinium (Gd), dysprosium (Dy), holmium (Ho), erbium (Er), oxygen (O), carbon (C), nitrogen (N), sulfur (S), phosphorus (P), fluorine (F), and chlorine (Cl).

23. The composite fiber according to any one of claims 1 to 22, wherein the ceramic sintered body is barium titanate or sodium bismuth titanate.

24. The composite fiber according to any one of claims 1 to 23, wherein the composite fiber has a tensile strength of 5 kgf/mm² or more.

25. The composite fiber according to any one of claims 1 to 24, the composite fiber having a flexibility with which the composite fiber has a radius of curvature of 200 mm or less.

26. The composite fiber according to any one of claims 1 to 25, wherein the composite fiber has a fiber size of 500 um or less.
